Europäisches Patentamt

(19) European Patent Office

Office européen des brevets

(11) Veröffentlichungsnummer: **0 111 274**
**B1**

(12) # EUROPÄISCHE PATENTSCHRIFT

(45) Veröffentlichungstag der Patentschrift:
25.01.89

(51) Int. Cl.⁴: **G 03 F 7/08**, G 03 F 7/10

(21) Anmeldenummer: 83112142.1

(22) Anmeldetag: 02.12.83

(54) **Lichtempfindliches Gemisch, daraus hergestelltes lichtempfindliches Kopiermaterial und Verfahren zur Herstellung einer Druckform aus dem Kopiermaterial.**

(30) Priorität: 13.12.82 DE 3246106

(43) Veröffentlichungstag der Anmeldung:
20.06.84 Patentblatt 84/25

(45) Bekanntmachung des Hinweises auf die Patenterteilung:
25.01.89 Patentblatt 89/4

(84) Benannte Vertragsstaaten:
CH DE FR GB IT LI NL

(56) Entgegenhaltungen:
EP-A-0 045 639
DD-A-206 518

IBM TECHNICAL DISCLOSURE BULLETIN, Band 23,
Nr. 2, Juli 1980, Seite 773, New York, US; H.
HIRAOKA: "Poly(p-vinyl phenol) and brominated
poly (p-vinyl phenol) as host resins for electron
beam resists"
PATENTS ABSTRACTS OF JAPAN, Band 5, Nr. 88 (P-
65) 760 , 9. Juni 1981; & JP - A - 56 35 129 (FUJI
YAKUHIN KOGYO K.K.) 07.04.1981

(73) Patentinhaber: HOECHST AKTIENGESELLSCHAFT,
Postfach 80 03 20, D-6230 Frankfurt am Main 80
(DE)

(72) Erfinder: Stahlhofen, Paul, Dr., Leibnizstrasse 18b,
D-6200 Wiesbaden (DE)

## Beschreibung

Positiv arbeitendes lichtempfindliches Gemisch, daraus hergestelltes lichtempfindliches Kopiermaterial und Verfahren zur Herstellung einer Druckform aus dem Kopiermaterial

Die Erfindung betrifft ein positiv arbeitendes lichtempfindliches Gemisch, das bei Belichtung seine Löslichkeit in einer wäßrig-alkalischen Lösungen erhöht und das eine lichtempfindliche Kombination von Verbindungen und ein wasserunlösliches, in wäßrig-alkalischen Lösungen lösliches Polyvinylphenol als Bindemittel enthält, ein positiv arbeitendes lichtempfindliches Kopiermaterial aus einem Schichtträger und einer lichtempfindlichen Schicht, die aus dem Gemisch besteht, sowie ein Verfahren zur Herstellung einer Druckform durch Belichten, Entwickeln und Erhitzen des Kopiermaterials.

Verfahren zur Herstellung von Druckformen durch Erhitzen bzw. Einbrennen der Bildschicht von belichteten und entwickelten Kopiermaterialien sind z. B. aus den britischen Patentschriften 1 151 199 und 1 154 749 bekannt. Dabei wird entweder ein positiv arbeitendes, bevorzugt ein o-Chinondiazid enthaltendes, oder ein negativ arbeitendes, bevorzugt ein p-Chinondiazid enthaltendes lichtempfindliches Kopiermaterial bildmäßig belichtet, entwickelt und danach auf eine oberhalb 180°C liegende Temperatur so lange und so hoch erhitzt, daß der zuvor sauber entwickelte Bildhintergrund durch Wärmezersetzungsprodukte der Bildschicht verschmutzt wird. Danach wird der Bildhintergrund durch nochmaliges Behandeln mit Entwicklerlösung wieder gesäubert. Normalerweise werden beim Erhitzen Temperaturen von 220 - 240°C angewendet, und die Dauer des Erhitzens beträgt etwa 5 - 60 Minuten. Durch diese Nachbehandlung wird eine Verfestigung der Druckschicht und damit eine erhebliche Erhöhung der Druckauflage erreicht. Wenn die Einbrenntemperaturen an der oberen Grenze des angegebenen Bereichs liegen, sind naturgemäß relativ kurze Einbrennzeiten erforderlich. Es hat sich gezeigt, daß die Anwendung höherer Temperaturen bei diesem Verfahren nachteilig ist. Sie bewirken einmal die Ausbildung eines verhältnismäßig festsitzenden Niederschlags auf den Hintergrundstellen, der nur durch relativ aggressive Lösungen sauber entfernt werden kann, wobei auch die Gefahr eines Angriffs auf die Druckschablone besteht. Zum zweiten besteht bei den höheren Einbrenntemperaturen oder bei längeren Einbrennzeiten die Gefahr, daß sich die üblicherweise verwendeten Schichtträger aus Aluminium verformen und die erhaltenen Druckformen geschädigt oder unbrauchbar werden.

Der zuerstgenannte Nachteil kann, wie es in der DE-A-2 626 473 beschrieben ist, dadurch vermieden werden, daß man die Hintergrundfläche vor dem Einbrennen mit einer Schicht einer wasserlöslichen organischen Substanz oder eines anorganischen Salzes überzieht, die sich nach dem Einbrennen leicht abwaschen läßt. Um die Verformung des Trägers zu verhindern, wäre es jedoch wünschenswert, bei tieferen Temperaturen einbrennen zu können. Außerdem wäre es wünschenswert, auf den zusätzlichen Arbeitsschritt der Zwischenbehandlung mit wäßriger Lösung verzichten zu können.

Aus der DE-A-3 107 109 ist ein lichtempfindliches Gemisch für die Herstellung von Flachdruckplatten bekannt, das als Bindemittel einen halogenierten Novolak enthält. Das Material hat eine verbesserte Resistenz gegenüber wäßrigalkalischen Entwicklerlösungen, gegenüber Kohlenwasserstofflösungsmitteln und Alkohol enthaltenden Feuchtwässern. Das Verhalten der entwickelten Druckschablonen gemäß dieser Druckschrift beim Einbrennen wird durch die Wahl dieser Novolake nicht verändert.

Aus der DE-A-2 322 230 sind lichtempfindliche Flachdruckplatten bekannt, die als Bindemittel Polyvinylphenole anstelle von Novolaken enthalten. Die damit erhaltenen Druckformen sollen sich durch besonders hohe Auflagenleistungen auszeichnen. Über das Verhalten dieser Druckformen nach dem Einbrennen ist nichts angegeben.

Aus IBM Technical Disclosure Bulletin, Bd. 23, Nr. 2, Juli 1980, Seite 773, sind für die Bestrahlung mit Elektronenstrahlen geeignete Photoresists bekannt aus einem Gemisch von Poly-(p-vinylphenol) und einem Diester von Dihydroxybenzophenon und einem o-Naphthochinondiazidsulfonsäurechlorid. Die Anwesenheit eines bromierten Poly(p-Vinylphenols) verbessert die Vernetzungsreaktion, so daß man dieses Bindemittel für lichtempfindliche Gemische zur Herstellung von Umkehrbildern einsetzen kann. Hieraus geht keineswegs hervor, daß man zur Herstellung von positiv arbeitenden lichtempfindlichen Gemischen halogenierte Poly-(p-vinylphenole) einsetzen kann. Es wird vielmehr offenbart, daß ihre Anwesenheit in positiv arbeitenden lichtempfindlichen Gemischen unerwünscht ist da ja wegen der Vernetzungsreaktion die Löslichkeit des Bindemittels erniedrigt wird.

Aus EP-A-0 045 639 ist ferner die Herstellung von negativ arbeitenden Photoresists bekannt, die in der lichtempfindlichen Schicht bromiertes Poly-(p-vinylphenol) enthalten.

Aufgabe der Erfindung war es, ein positiv arbeitendes lichtempfindliches Gemisch bzw. ein daraus hergestelltes Kopiermaterial herzustellen, das für die Herstellung von Flachdruckformen geeignet ist und das sich nach dem Belichten und Entwickeln unter solchen Bedingungen einbrennen läßt, daß keine schwierig entfernbaren Einbrennrückstände auf den bildfreien Stellen des Schichtträgers entstehen und daß auf eine Zwischenbehandlung durch Aufbringen einer wasserlöslichen Schutzschicht verzichtet werden kann.

Erfindungsgemäß wird ein positiv arbeitendes lichtempfindliches Gemisch vorgeschlagen, das bei Belichtung seine Löslichkeit in einer wäßrig-alkalischen Lösung erhöht und das eine lichtempfindliche Kombination von Verbindungen und ein wasserunlösliches, in wäßrig-alkalischen Lösungen lösliches Polyvinylphenol als Bindemittel enthält. Das erfindungsgemäße Gemisch ist dadurch gekennzeichnet, daß das Polyvinylphenol halogeniert ist und daß es als lichtempfindliche Kombination ein Gemisch aus

a)     einer bei Belichtung Säure abspaltenden Verbindung und
b)     einer Verbindung enthält, die mindestens eine durch Säure spaltbare C-O-C-Bindung aufweist.

Erfindungsgemäß wird ferner ein positiv arbeitendes lichtempfindliches Kopiermaterial bestehend aus einem Schichtträger und einer lichtempfindlichen Schicht vorgeschlagen, die aus dem oben definierten Gemisch besteht. Erfindungsgemäß wird weiterhin ein Verfahren zur Herstellung einer Druckform vorgeschlagen, bei dem ein positiv arbeitendes lichtempfindliches Kopiermaterial, bestehend aus einem Schichtträger und einer lichtempfindlichen Schicht, die bei Belichtung ihre Löslichkeit in einer wäßrig-alkalischen Lösung erhöht und die eine lichtempfindliche Kombination von Verbindungen und ein wasserunlösliches, in wäßrig-alkalischen Lösungen lösliches Polyvinylphenol als Bindemittel enthält, bildmäßig belichtet wird, die Nichtbildstellen der Schicht mit einer wäßrig-alkalischen Entwicklerlösung ausgewaschen werden und das Material danach zur Verfestigung der Bildschicht auf erhöhte Temperatur erhitzt wird.

Als halogenierte Vinylphenolpolymerisate werden vorzugsweise chlorierte oder bromierte, insbesondere bromierte Polymerisate verwendet. Außer halogenierten Homopolymerisaten können auch Mischpolymerisate von halogenierten Vinylphenolen mit anderen Vinylverbindungen, z. B. Styrol oder Acrylsäureestern, eingesetzt werden. Im allgemeinen werden die Polymerisate des p-Vinylphenols bevorzugt. Der Halogengehalt der halogenierten Polyvinylphenole liegt im allgemeinen zwischen 20 und 60, vorzugsweise zwischen 40 und 58 Gew.-%.

Die Herstellung des bromierten Poly-p-vinylphenols erfolgt in bekannter Weise durch Bromieren des entsprechenden p-Vinylphenol-Polymerisats. Die Poly-Vinylphenole selbst können durch Block-, Emulsions-oder Lösungs-Polymerisation der entsprechenden Monomeren in Gegenwart eines kationischen Katalysators hergestellt werden. Sie können aber auch durch radikalische Polymerisation in Gegenwart geeigneter Katalysatoren wie Azodiisobuttersäurenitril erhalten werden.

Derartige Polymerisationsverfahren sind beschrieben in "Journal of Polymer Science", Teil A-1, Bd. 7 (1969), Seiten 2175 bis 2184 und 2405 bis 2410 oder in "Journal of Organic Chemistry", Bd. 24 (1959), Seiten 1345 bis 1347.

Die Konzentration der halogenierten Polyvinylphenole in dem lichtempfindlichen Gemisch kann je nach der Natur des lichtempfindlichen Systems sehr unterschiedlich sein. Im allgemeinen liegt der Anteil zwischen 10 und 95, vorzugsweise zwischen 40 und 80 Gew.-%, bezogen auf das Gewicht der nichtflüchtigen Bestandteile des lichtempfindlichen Gemisches.

Die erfindungsgemäßen lichtempfindlichen Gemische enthalten eine lichtempfindliche Kombination von Verbindungen. Geeignet sind vor allem Kombinationen von photolytischen Säurespendern und säurespaltbaren Verbindungen, wie Orthocarbonsäure- und Acetalverbindungen.

Das erfindungsgemäße Gemisch und Verfahren haben besondere Vorteile in Verbindung mit lichtempfindlichen Materialien auf Basis säurespaltbarer Verbindungen, da deren Druckauflage durch Einbrennen eine große Erhöhung erfährt.

Kopiermaterialien dieser Art sind bekannt und z. B. in den US-A-3 779 778 und 4 101 323, der DE-C-2 718 254 und den DE-A 2 829 512 und 2 829 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine oder 2-Trichlormethyl-1,3,4-oxadiazole.

Von den in der US-A-4 101 323 beschriebenen Orthocarbonsäurederivaten werden besonders die Bis-1,3-dioxan-2-yl-ether von aliphatischen Diolen verwendet.

Von den in der DE-C-2 718 254 beschriebenen Polyacetalen werden diejenigen mit aliphatischen Aldehyd- und Dioleinheiten bevorzugt.

Weitere gut geeignete Gemische sind in der DE-A-2 928 636 beschrieben. Dort werden als säurespaltbare Verbindungen polymere Orthoester mit wiederkehrenden Orthoestergruppen in der Hauptkette beschrieben.

Diese Gruppen sind 2-Alkylether von 1,3-Dioxacycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure abspaltenden Verbindung liegt zwischen 0,1 und 10, vorzugsweise zwischen 0,2 und 5 Gew.-%.

In den erfindungsgemäßen lichtempfindlichen Gemischen können zusätzlich zu den halogenierten Polyvinylphenolen noch zahlreiche andere Harze mitverwendet werden, bevorzugt Vinylpolymerisate wie Polyvinylacetate, Polyacrylate, Polyvinylether, Polyvinylacetale, Polyvinylpyrrolidone und die Mischpolymerisate der ihnen zugrundeliegenden Monomeren. Als weitere alkalilösliche bzw. in Alkali quellbare Bindemittel sind natürliche Harze wie Schellack und Kolophonium und synthetische Harze wie Mischpolymerisate aus Styrol und Maleinsäureanhydrid und insbesondere Novolake zu nennen. Der günstigste Anteil an diesen Harzen richtet sich nach den anwendungstechnischen Erfordernissen und dem Einfluß auf die Entwicklungsbedingungen und beträgt im allgemeinen nicht mehr als 60 Gew.-% vom halogenierten Polyvinylphenol. In geringen Mengen kann das lichtempfindliche Gemisch für spezielle Erfordernisse wie Flexibilität, Haftung, Glanz, Färbung und Farbumschlag außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z. B. mit Polyvinylphosphonsäure, Silikaten, Hexafluorozirkonaten, hydrolysiertem Tetraethylorthosilikat oder Phosphaten, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln der positiv arbeitenden Kopiermaterialien verwendeten wäßrig-alkalischen Lösungen abgestufter Alkalität, d. h. mit einem pH, das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage. Negativschichten können mit ähnlichen Entwicklern verarbeitet werden.

Bevorzugte Anwendung finden die erfindungsgemäßen lichtempfindlichen Gemische bei der Herstellung von Druckformen, insbesondere Offsetdruckformen, mit Aluminium als Schichtträger.

Nach dem Entwickeln kann die Druckform in an sich bekannter Weise erhitzt werden. Die Einbrenntemperaturen können im Bereich von etwa 180 bis 240° C, vorzugsweise von 200 bis 240° C, gewählt werden, wobei normalerweise Erhitzungszeiten von 1 bis 20, bevorzugt 5 bis 10 Minuten, erforderlich sind. Wenn das Trägermaterial gegen höhere Temperaturen beständig ist, ist es selbstverständlich auch möglich, bei höheren Temperaturen oberhalb 240° C einzubrennen und dementsprechend kürzere Erhitzungszeiten zu wählen.

Das erfindungsgemäße Gemisch und das daraus hergestellte lichtempfindliche Kopiermaterial zeichnen sich dadurch aus, daß sie beim Einbrennen der fertig entwickelten Druckform praktisch keine Einbrennrückstände auf den bildfreien Bereichen des Trägers ergeben.

Das zusätzliche Aufbringen einer wasserlöslichen Schutzschicht vor dem Einbrennen oder das nachträgliche Entfernen der Rückstände durch Behandeln mit Entwickler können deshalb entfallen.

Dieser Vorteil wird weder mit den bekannten halogenierten Novolaken noch mit den nicht halogenierten erreicht. Ein weiterer Vorteil der Verwendung von halogenierten Polyvinylphenolen gegenüber nicht halogenierten Polyvinylphenolen als Bindemittel ist die wesentlich verbesserte Resistenz der nicht eingebrannten Druckschablone gegenüber Druckhilfsmitteln, z. B. bestimmten Kohlenwasserstofflösungsmitteln oder Alkohol enthaltenden Feuchtwässern, wie sie üblicherweise während der Kopierarbeiten oder an der Druckmaschine verwendet werden.

Die Erfindung wird anhand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

**Beispiel 1**

Mit einer Lösung von

| | | |
|---|---|---|
| 2,40 | Gt | einer 50-%-igen Lösung eines Polyorthoesters in Toluol, hergestellt aus 7,7-Bis-hydroxymethyl-5-oxa-nonanol-(1) und Orthoameisensäuretrimethylester, |
| 0,20 | Gt | 2-(4-Ethoxy-naphth-1-yl)-4,6-bis-trichlor-methyl-s-triazin, |
| 5,00 | Gt | des in Beispiel 1 angegebenen bromierten Polyvinylphenols und |
| 0,035 | Gt | Kristallviolettbase in |
| 30 | Gt | Ethylenglykolmonomethylether und |
| 40 | Gt | Tetrahydrofuran |

wurde eine elektrochemisch aufgerauhte und anodisierte Aluminiumplatte beschichtet. Der anodisierte Träger war vor dem Aufbringen der lichtempfindlichen Kopierschicht mit einer wäßrigen Lösung von 0,1 Gewichtsprozent Polyvinylphosphonsäure behandelt worden.

Das so hergestellte vorsensibilisierte Material mit einem Schichtgewicht von ca. 2,0 g/m² wurde unter einer 5 kW-Metallhalogenid Lampe im Abstand von 110 cm bildmäßig belichtet und anschliessend mit einer 0,5-%-igen wäßrigen Lösung von Natriummetasilikat x 9 Wasser entwickelt.

Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt.

Von der so hergestellten Druckform konnten in einer Offsetdruckmaschine 100 000 einwandfreie Drucke hergestellt werden.

Zwecks Erhöhung der Druckauflage und Verfestigung der Druckschablone wurde die Druckform einer Wärmebehandlung unterzogen. Zu diesem Zweck wurde die getrocknete Druckform nach dem Entwickeln in einem Einbrennofen 5 Minuten auf 230°C erhitzt.

Durch das Erhitzen der Druckform im Ofen trat eine Verfestigung der Druckschablone ein, und die Schicht wurde resistent gegenüber Chemikalien, z. B. Korrekturmitteln, und unlöslich in organischen Lösungsmitteln, wie Aceton, Alkoholen, Toluol oder Xylol.

Nach dem Erhitzungsvorgang kann die Druckschablone sofort mit fetter Farbe in Gegenwart von Wasser eingefärbt werden, ohne daß eine zusätzliche Nachbehandlung der Druckform notwendig ist. In einer Offsetdruckmaschine konnten 250 000 einwandfreie Drucke hergestellt werden.

Der Vorteil der erfindungsgemäß eingesetzten halogenierten Polyvinylphenole gegenüber nicht halogenierten Polyvinylphenolen als Bindemittel in lichtempfindlichen Gemischen wird deutlich, wenn das bromierte Poly-p-vinylphenol durch das entsprechende nicht bromierte Poly-p-vinylphenol ersetzt wird. Während bereits nach einem Einbrennvorgang von 5 Minuten bei 230°C die Druckschablone resistent gegenüber Korrekturmittel und unlöslich in organischen Lösungsmitteln, z. B. Aceton, geworden ist, wird bei der entsprechenden Druckform mit dem nicht bromierten Poly-p-vinylphenol als Bindemittel selbst nach einer Einbrennzeit von 10 Minuten bei 230°C die Druckschablone unter sonst gleichen Versuchsbedingungen von Korrekturmittel aufgelöst, und die Schicht bleibt löslich in Aceton.

Auch die noch nicht eingebrannte erfindungsgemäße Druck schablone zeigt gegenüber Druckhilfsmitteln, z. B. Feuchtwasser, Walzenwaschmittel oder Plattenauswaschmittel, eine ausgezeichnete Resistenz. Während sie gegenüber einer mit Phosphorsäure angesäuerten 50-%-igen Isopropanol-Lösung noch nach 5-minütiger Einwirkung keinen sichtbaren Angriff zeigt, ist die entsprechende Vergleichsdruckschablone mit Poly-p-vinylphenol als Bindemittel bereits nach 15 Sekunden abgelöst.

Ersetzt man das bromierte Poly-p-vinylphenol durch die gleiche Menge eines Kresol-Formaldehyd-Novolaks oder eines bromierten Kresol-Formaldehyd-Novolaks mit 39 % Bromgehalt, wie er in der DE-A-3 107 109 beschrieben ist, und brennt die entwickelten Druckformen unter sonst gleichen Bedingungen bei 230°C ein, so resultiert im Gegensatz zu der entsprechenden Druckform mit Poly-p-vinylbromphenol als Bindemittel beim Einfärben mit fetter Farbe starker Ton an den bildfreien Stellen, der nicht mehr zu entfernen ist.

**Beispiel 2**

Mit einer Lösung von

| | | |
|---|---|---|
| 0,55 | Gt | eines Polyacetals, hergestellt aus Triethylenglykol und 2-Ethylbutyraldehyd, |
| 0,10 | Gt | 2-(4-Ethoxy-naphth-1-yl)-4,6-bis-trichlormethyl-s-triazin, |
| 1,50 | Gt | des in Beispiel 1 angegebenen bromierten Poly-p-vinylphenols, |
| 0,50 | Gt | eines Kresol-Formaldehyd-Novolaks mit einem Erweichungspunkt von 105 bis 120°C und |
| 0,016 | Gt | Kristallviolett-Base in |
| 20 | Gt | Ethylenglykolmonomethylether und |
| 20 | Gt | Tetrahydrofuran |

wurde eine elektrochemisch aufgerauhte und anodisierte Aluminiumplatte beschichtet.

Die so hergestellte Druckplatte wurde 10 Sekunden unter einer 5 kW-Metallhalogenidlampe im Abstand von 110 cm bildmäßig belichtet und anschließend mit einer 1-%-igen wäßrigen Natriummetasilikatlösung entwickelt.

## Patentansprüche

1. Positiv arbeitendes lichtempfindliches Gemisch, das bei Belichtung seine Löslichkeit in einer wäßrig-alkalischen Lösung erhöht und das eine lichtempfindliche Kombination von Verbindungen und ein wasserunlösliches, in wäßrig-alkalischen Lösungen lösliches Polyvinylphenol als Bindemittel enthält, dadurch gekennzeichnet, daß das Polyvinylphenol halogeniert ist, und das es als lichtempfindliche Kombination ein Gemisch aus:

a) einer bei Belichtung Säure abspaltenden Verbindung und
b) einer Verbindung enthält, die mindestens eine durch Säure spaltbare C-O-C-Bindung aufweist.

2. Gemisch nach Anspruch 1, dadurch gekennzeichnet, daß das Polyvinylphenol bromiert ist.

3. Gemisch nach Anspruch 1, dadurch gekennzeichnet, daß das Polyvinylphenol ein Polymerisat des p-Vinylphenols ist.

4. Gemisch nach Anspruch 1, dadurch gekennzeichnet, daß der Mengenanteil an halogeniertem Polyvinylphenol 10 bis 95 Gew.-%, bezogen auf die nichtflüchtigen Anteile des Gemischs, beträgt.

5. Gemisch nach Anspruch 1, dadurch gekennzeichnet, daß das halogenierte Polyvinylphenol einen Halogengehalt im Bereich von 20 bis 60 Gew.-% hat.

6. Positiv arbeitendes lichtempfindliches Kopiermaterial, bestehend aus einem Schichtträger und einer lichtempfindlichen Schicht, aus einem Gemisch nach Ansprüchen 1 bis 5.

7. Verfahren zur Herstellung einer Druckform, bei dem ein positiv arbeitendes lichtempfindliches Kopiermaterial, bestehend aus einem Schichtträger und einer lichtempfindlichen Schicht, aus einem Gemisch nach Ansprüchen 1 bis 5, bildmäßig belichtet wird, die Nichtbildstellen der Schicht mit einer wäßrigalklischen Entwicklerlösung ausgewaschen werden und das Material danach zur Verfestigung der Bildschicht auf erhöhte Temperatur erhitzt wird.

## Claims

1. Positive-working, light-sensitive mixture, the solubility of which in an aqueous-alkaline solution is increased on exposure and which contains a light-sensitive compound or a light-sensitive combination of compounds and, as the binder, a polyvinyl phenol which is insoluble in water, but soluble in aqueous-alkaline solutions, wherein the polyvinyl phenol is halogenated and wherein said mixture contains, as the light-sensitive combination, a composition comprising:

a) a compound which eliminates an acid on exposure and
b) a compound which containes at least one acid-cleavable C-O-C-bond.

2. Light-sensitive mixture as claimed in Claim 1, wherein the polyvinyl phenol is brominated.

3. Light-sensitive mixture as claimed in Claim 1, wherein the polyvinyl phenol is a polymer of p-vinyl phenol.

4. Light-sensitive mixture as claimed in Claim 1, wherein the quantitative portion of halogenated polyvinyl phenol is 10 to 95 % by weight, relative to the non-volatile constituents of the mixture.

5. Light-sensitive mixture as claimed in Claim 1, wherein the halogenated polyvinyl phenol has a halogen content of between 20 and 60 % by weight.

6. Positive-working, light-sensitive copying material composed of a layer support and a light-sensitive layer comprising a mixture as claimed in claims 1 to 5.

7. Process for the preparation of a printing form, in which a light-sensitive copying material composed of a layer support and a light-sensitive layer comprising a mixture as claimed in claims 1 to 5 is exposed imagewise, the non-image areas of the layer are washed out with an aqueous-alkaline developer solution, and the material is then heated to an elevated temperature in order to harden the image layer.

## Revendications

1. Mélange photosensible travaillant en positif, dont la solubilité dans une solution aqueuse alcaline augmente lors d'exposition, et qui contient une combinaison photosensible de composés et, en tant que liant, un polyvinylphénol insoluble dans l'eau, soluble dans des solutions aqueuses alcalines, caractérisé en ce qu'il contient, en tant que combinaison photosensible, un mélange de:

a) un composé libérant un acide lors d'exposition, et
b) un composé qui comporte au moins une liaison C-O-C pouvant être rompue par un acide,

et en ce que le polyvinylphénol est halogéné.

2. Mélange selon la revendication 1, caractérisé en ce que le polyvinylphénol est bromé.

3. Mélange selon la revendication 1, caractérisé en ce que le polyvinylphénol est un polymère du p-vinylphénol.

4. Mélange selon la revendication 1, caractérisé en ce que la proportion de polyvinylphénol halogéné est de 10 à 95 % en poids, par rapport aux composants non volatiles du mélange.

5. Mélange selon la revendication 1, caractérisé en ce que le polyvinylphénol halogéné a une

teneur en halogène dans la plage de 20 à 60 % en poids.

6. Matériau photosensible de copie travaillant en positif, composé d'un support de couche et d'une couche photosensible à base d'un mélange selon les revendications 1 à 5.

7. Procédé pour la production d'une forme d'impression, dans lequel on expose selon l'image le matériau photosible de copie travaillant en positif, composé d'un support de couche et d'une couche photosensible à base d'un mélange selon les revendications 1 à 5, on élimine les zones de non image de la couche par lavage avec une solution aqueuse alcaline de développement, et après cela on chauffe le matériau à haute température pour le durcissement de la couche d'image.